(19) Europäisches Patentamt
European Patent Office
Office européen des brevets

(11) **EP 4 653 896 A1**

(12) **EUROPEAN PATENT APPLICATION**
published in accordance with Art. 153(4) EPC

(43) Date of publication:
**26.11.2025 Bulletin 2025/48**

(21) Application number: **24863015.4**

(22) Date of filing: **25.07.2024**

(51) International Patent Classification (IPC):
$G01R\ 31/392^{(2019.01)}$    $G01R\ 31/396^{(2019.01)}$
$G01R\ 31/385^{(2019.01)}$    $G01R\ 31/367^{(2019.01)}$
$G01R\ 31/36^{(2020.01)}$    $G01R\ 31/382^{(2019.01)}$
$G01R\ 19/165^{(2006.01)}$    $H01M\ 10/052^{(2010.01)}$
$H01M\ 10/48^{(2006.01)}$

(52) Cooperative Patent Classification (CPC):
**B60L 58/16; G01R 19/165; G01R 31/36;
G01R 31/367; G01R 31/382; G01R 31/385;
G01R 31/392; G01R 31/396; H01M 10/052;
H01M 10/48; H02J 7/00;** Y02E 60/10

(86) International application number:
**PCT/KR2024/010819**

(87) International publication number:
**WO 2025/053433 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.09.2023 KR 20230117255**

(71) Applicant: **LG Energy Solution, Ltd.
Seoul 07335 (KR)**

(72) Inventors:
• **KIM, Tae-Hyeon
Daejeon 34122 (KR)**
• **KIM, Young-Deok
Daejeon 34122 (KR)**
• **CHOI, Hyun-Jun
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY DIAGNOSIS APPARATUS, BATTERY PACK, ELECTRIC VEHICLE AND BATTERY DIAGNOSIS METHOD**

(57) There are provided a battery diagnosis apparatus, a battery pack, an electric vehicle and a battery diagnosis method. The battery diagnosis apparatus includes a sensing unit to acquire capacity-voltage relationship data of a battery cell, and a control circuit to generate a Q-V profile, a normalized Q-V profile and a Q-dV/dQ profile based on the capacity-voltage relationship data. The control circuit determines a profile feature parameter of a Q-V profile of interest, wherein the Q-V profile of interest is a higher capacity side part of the normalized Q-V profile on the basis of a cut-off reference point detected in the Q-dV/dQ profile. The control circuit determines at least one degradation parameter based on the profile feature parameter.

FIG. 1

**Description**

TECHNICAL FIELD

The present disclosure relates to diagnosis of degradation in battery cells.

The present application claims priority to Korean Patent Application No. 10-2023-0117255 filed on September 4, 2023 in the Republic of Korea, the disclosure of which is incorporated herein by reference.

BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Currently, commercially available batteries include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

There are many different degradation monitoring techniques for battery cells. In particular, Differential Voltage Analysis (DVA) is based on time-series data of at least one battery parameter (for example, voltage, current) that can be observed outside of battery cells.

In DVA, peaks in a differential voltage curve (also referred to as a 'Q-dV/dQ profile') are considered as key factors, and some types of battery cells have a voltage plateau characteristic that a change in voltage is maintained at almost 0 during charging or discharging. Because differential voltage is also close to 0 in the capacity range in which the voltage plateau characteristic is found, it is difficult to detect a peak from the Q-dV/dQ profile. Accordingly, there is a need for an approach to diagnose degradation in battery cells accurately and easily without extracting peak information indicating degradation from the Q-dV/dQ profile.

DISCLOSURE

Technical Problem

The present disclosure is designed to solve the above-described problem, and therefore the present disclosure is directed to providing a battery diagnosis apparatus and method for precisely estimating at least one degradation parameter for a degradation state of a battery cell having voltage plateau characteristic without disassembling the battery cell.

These and other objectives and advantages of the present disclosure may be understood from the following description and will become apparent from the exemplary embodiments of the present disclosure. Also, it will be easily understood that the objectives and advantages of the present disclosure may be realized by the means set forth in the appended claims and a combination thereof.

Technical Solution

A battery diagnosis apparatus according to an aspect of the present disclosure includes a data acquisition unit configured to acquire capacity-voltage relationship data of a battery cell; and a control circuit configured to generate a Q-V profile indicating a correspondence relationship between a capacity and a voltage of the battery cell, a normalized Q-V profile indicating a correspondence relationship between a normalized capacity and the voltage of the battery cell and a Q-dV/dQ profile indicating a correspondence relationship between the normalized capacity and a differential voltage of the battery cell based on the capacity-voltage relationship data. The control circuit identifies a cut-off reference point located in a reference capacity range from the Q-dV/dQ profile. The control circuit determines a profile feature parameter associated with a Q-V profile of interest, wherein the Q-V profile of interest is a higher capacity side part of the normalized Q-V profile on the basis of a capacity value of the cut-off reference point. The control circuit determines at least one degradation parameter of the battery cell based on the profile feature parameter.

The control circuit may generate the normalized Q-V profile by normalizing the Q-V profile based on an entire capacity range of the Q-V profile. The control circuit may generate the Q-dV/dQ profile by differentiating the normalized Q-V profile.

The control circuit may be configured to set a local minimum point in the reference capacity range as the cut-off reference point from the Q-dV/dQ profile.

The control circuit may be configured to generate a corrected Q-V profile of interest by performing a profile tuning procedure for matching a start point and an end point of the Q-V profile of interest to a first reference point and a second reference point, respectively. The control circuit may be configured to determine an area of a region of interest defined by the corrected Q-V profile of interest, the first reference point and the second reference point as the profile feature parameter.

The control circuit may be configured to determine a first degradation parameter by using the determined area as an input variable of a linear regression model. The linear regression model may be prepared beforehand as a relationship function between the profile feature parameter and a positive electrode degradation state.

The first degradation parameter may indicate a capacity reduction ratio by positive electrode degradation of the battery cell.

The control circuit may determine a second degradation parameter based on a total capacity reduction ratio of the battery cell and the first degradation parameter. The second degradation parameter may indicate a capacity reduction ratio by loss of available lithium of the battery cell.

The capacity-voltage relationship data may indicate a capacity change history and a voltage change history of the battery while the battery cell is charged or discharged.

A battery pack according to another aspect of the present disclosure includes the battery diagnosis apparatus.

An electric vehicle according to still another aspect of the present disclosure includes the battery pack.

A battery diagnosis method according to further another aspect of the present disclosure includes acquiring capacity-voltage relationship data of a battery cell; generating a Q-V profile indicating a correspondence relationship between a capacity and a voltage of the battery cell, a normalized Q-V profile indicating a correspondence relationship between a normalized capacity and the voltage of the battery cell and a Q-dV/dQ profile indicating a correspondence relationship between the normalized capacity and a differential voltage of the battery cell based on the capacity-voltage relationship data; identifying a cut-off reference point located in a reference capacity range from the Q-dV/dQ profile; determining a profile feature parameter associated with a Q-V profile of interest, wherein the Q-V profile of interest is a higher capacity side part of the normalized Q-V profile on the basis of a capacity value of the cut-off reference point; and determining at least one degradation parameter of the battery cell based on the profile feature parameter.

The generating of the Q-dV/dQ profile may include generating the normalized Q-V profile by normalizing the Q-V profile based on an entire capacity range of the Q-V profile; and generate the Q-dV/dQ profile by differentiating the normalized Q-V profile.

The determining of the profile feature parameter of the battery cell may include generating a corrected Q-V profile of interest by performing a profile tuning procedure for matching a start point and an end point of the Q-V profile of interest to a first reference point and a second reference point, respectively; and determining an area of a region of interest defined by the corrected Q-V profile of interest, the first reference point and the second reference point as the profile feature parameter.

The determining of the at least one degradation parameter of the battery cell may include determining a first degradation parameter by inputting the determined area to a linear regression model as an input variable. The linear regression model may be prepared beforehand as a relationship function between the profile feature parameter and a positive electrode degradation state.

The determining of the at least one degradation parameter of the battery cell may further include determining a second degradation parameter based on a total capacity reduction ratio of the battery cell and the first degradation parameter. The second degradation parameter may indicate a capacity reduction ratio by loss of available lithium of the battery cell.

Advantageous Effects

According to at least one of the embodiments of the present disclosure, it may be possible to precisely estimate at least one degradation parameter for the degradation state of the battery cell without disassembling the battery cell. In particular, the present disclosure may diagnose the positive electrode degradation state of LFP battery cells having voltage plateau characteristic in a nondestructive manner.

Additionally, according to at least one of the embodiments of the present disclosure, it may be possible to determine the positive electrode degradation state (for example, the positive electrode degradation derived capacity degradation ratio) of the battery cell more precisely by extracting and analyzing a part (the 'Q-V profile of interest' as described below) of the voltage curve in which the degradation characteristics of the positive electrode material dominate the degradation characteristics of the negative electrode material in the entire voltage curve (the 'Q-V profile' as described below) of the battery cell for the predetermined voltage range.

Additionally, according to at least one of the embodiments of the present disclosure, it may be possible to easily calculate the lithium loss derived capacity reduction ratio from the total capacity reduction ratio and the positive electrode degradation derived capacity reduction ratio of the battery cell by using a relationship between the total capacity reduction ratio, the positive electrode degradation derived capacity reduction ratio and the lithium loss derived capacity reduction ratio of the battery cell.

The effects of the present disclosure are not limited to the aforementioned effects, and these and other effects will be clearly understood by those skilled in the art from the appended claims.

BRIEF DESCRIPTION OF THE DRAWINGS

The accompanying drawings illustrate exemplary embodiments of the present disclosure and together with the following detailed description, serve to provide a better understanding of the technical aspect of the present disclosure, and thus the present disclosure should not be construed as being limited to the drawings.

FIG. 1 is a diagram exemplarily showing an electric vehicle according to the present disclosure.

FIG. 2 is a graph showing an example of a Q-V profile of a battery cell.

FIG. 3 shows an example of a normalized Q-V profile acquired from the Q-V profile of FIG. 2.

FIG. 4 shows an example of a Q-dV/dQ profile in association with the normalized Q-V profile shown in FIG. 3.

FIG. 5 is a graph showing an example of a Q-V profile of interest extracted from the normalized Q-V profile of FIG. 4.

FIG. 6 shows an example of a corrected Q-V profile of interest acquired from the Q-V profile of interest of FIG. 5.

FIG. 7 is a diagram referenced in exemplarily describing a relationship between different positive electrode degradation levels and corrected Q-V profiles of interest.

FIG. 8 is a diagram referenced in exemplarily describing a relationship between different positive electrode degradation levels and an area of a region of interest.

FIG. 9 is a flowchart schematically showing a battery diagnosis method according to an embodiment of the present disclosure.

FIG. 10 is a flowchart exemplarily showing the sub-routines that may be included in the step S920 in FIG. 9.

FIG. 11 is a flowchart exemplarily showing the sub-routines that may be included in the step S930 in FIG. 9.

FIG. 12 is a flowchart exemplarily showing the sub-routines that may be included in the step S950 in FIG. 9.

BEST MODE

Hereinafter, the exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time the application was filed.

The terms including the ordinal number such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "control circuit 130" as used herein refers to a processing unit of at least one function or operation, and may be implemented by hardware and software either alone or in combination.

**In** addition, throughout the specification, it will be further understood that when an element is referred to as being "connected to" another element, it can be directly connected to the other element or intervening elements may be present.

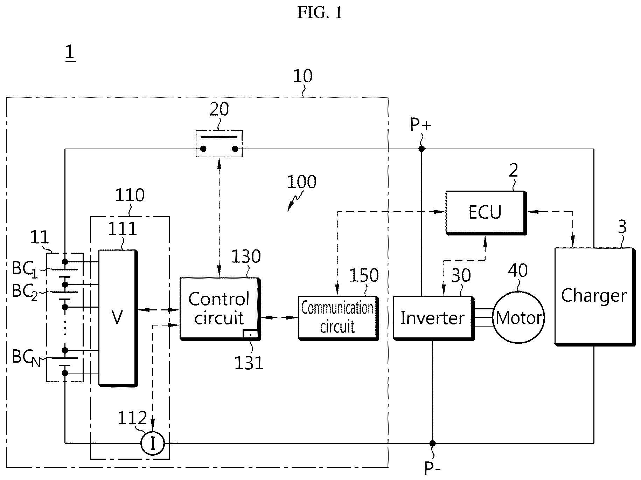

FIG. 1 is a diagram exemplarily showing an electric vehicle according to the present disclosure.

Referring to FIG. 1, the electric vehicle 1 includes a system controller 2, a battery pack 10, an inverter 30 and an electric motor 40. Charge/discharge terminals P+, P- of the battery pack 10 may be electrically coupled to a charger 3 through a charging cable. The charger 3 may be included in the electric vehicle 1, or may be present in a charging station. The electric vehicle 1 is an example of a battery system that is a system of the upper level concept including the battery pack 10 for at least one of energy storage or energy supply. Accordingly, the following description may be commonly applied to the battery system including the electric vehicle 1.

The system controller 2 (for example, an Electronic Control Unit (ECU)) is configured to transmit a key-on signal to a battery diagnosis apparatus 100 in response to a user's changing a starter button (not shown) of the electric vehicle 1 to an ON-position. The system controller 2 is configured to transmit a key-off signal to the battery diagnosis apparatus 100 in response to the user's changing the starter button to an OFF-position. The charger 3 may supply a charge power selected from constant power, constant current and constant voltage through the charge/discharge terminals P+, P- of the battery pack 10 via communication with the system controller 2.

The battery pack 10 includes a battery 11 and a relay 20. The battery pack 10 may further include the battery diagnosis apparatus 100.

The battery 11 includes at least one battery cell BC. In FIG. 1, the battery 11 including a plurality of battery cells $BC_1 \sim BC_N$ (N is a natural number of 2 or greater) connected in series is shown by way of illustration. The plurality of battery cells $BC_1 \sim BC_n$ may be provided with the same electrochemical specification. Hereinafter, in the common description of the plurality of battery cells $BC_1 \sim BC_N$, the symbol 'BC' is affixed to the battery cell. The charger 3 may perform charge/-discharge cycles needed to diagnose the degradation state of the battery cell BC through collaboration with the inverter 30 having a discharge function.

The battery cell BC is to be diagnosed by the battery diagnosis apparatus 100. The battery cell BC is not limited to a particular type and may include any electrochemical device that can be repeatedly charged and discharged. Preferably, the battery cell BC may be a lithium iron phosphate battery cell having voltage plateau characteristic. The voltage plateau characteristic refers to a characteristic that a change in voltage is kept less than a predetermined threshold over at least one capacity range (or SOC range). The lithium iron phosphate battery cell may be also referred to as 'LiFePO$_4$ battery cell', 'LFP battery cell' or 'LFP cell'. Hereinafter, assume that the battery cell BC is a LFP battery cell including LFP and graphite as the positive electrode material and the negative electrode material, respectively.

The relay 20 is electrically connected in series to the battery 11 through a power path connecting the battery 11 and the inverter 30. FIG. 1 shows the relay 20 connected between a positive terminal of the battery 11 and the charge/discharge terminal P+. The relay 20 is controlled to turn on/off in response to the switching signal from the battery diagnosis apparatus 100. The relay 20 may be a mechanical contactor that turns on or off by the magnetic force of a coil or a semiconductor switch such as Metal Oxide Semiconductor Field Effect transistor (MOSFET).

The inverter 30 is provided to convert a direct current from the battery 11 included in the battery pack 10 to an alternating current in response to a command from the battery diagnosis apparatus 100 or the system controller 2. The electric motor 40 operates using the alternating current from the inverter 30. The electric motor 40 may include, for example, a 3-phase alternating current motor. The components in the battery system supplied with the discharge power of the battery 11 including the inverter 30 and the electric motor 40 may be referred collective to as an electrical load.

The battery diagnosis apparatus 100 may be implemented as a sort of cloud server disposed at a remote location from the battery pack 10. The battery diagnosis apparatus 100 includes a control circuit 130. The battery diagnosis apparatus 100 may further include at least one of a sensing unit 110 or a communication circuit 150. The 'data acquisition unit' described in the appended claims may refer to either the sensing unit 110 or the communication circuit 150 or both.

The sensing unit 110 includes a voltage sensor 111. The sensing unit may further include a current sensor 112.

The voltage sensor 111 is connected to the positive and negative terminals of the battery cell BC, and is configured to detect a voltage (referred to as 'full cell voltage') across the battery cell BC, and generate a voltage signal indicating a detection value of the detected voltage. The voltage sensor 111 may include one of known voltage detection devices such as a voltage measurement IC or a combination thereof.

The current sensor 112 is connected in series to the battery 11 through the current path between the battery 11 and the inverter 30. The current sensor 112 is configured to detect a current (referred to as 'charge/discharge current') flowing through the battery 11, and generate a current signal indicating a detection value of the detected current. Because the plurality of battery cells $BC_1 \sim BC_N$ is connected in series, the current flowing in the battery 11 is the same as the current flowing in the battery cell BC. The current sensor 112 may include one of known current detection devices such as a shunt resistor or a Hall-effect device or a combination thereof.

The communication circuit 150 is configured to support wired or wireless communication between the control circuit 130 and the system controller 2. The wired communication may be, for example, controller area network (CAN) communication, and the wireless communication may be, for example, Zigbee or Bluetooth communication. The communication protocol is not limited to a particular type and may include those that support the wired/wireless communication between the control circuit 130 and the system controller 2. The communication circuit 150 may include an output device (for example, a display, a speaker) to provide information received from the control circuit 130 and/or the system controller 2 into a recognizable format for the user (the driver).

The control circuit 130 is operably coupled to the relay 20, the voltage sensor 111 and the communication circuit 150. The operably coupled refers to direct/indirect connection to enable signal transmission and reception in one or two directions.

The control circuit 130 may collect the voltage signal from the voltage sensor 111 and the current signal from the current sensor 112. In the specification, the detection signal as used herein may refer to the voltage signal alone or both the voltage signal and the current signal. That is, the control circuit 130 may convert and record each analogue signal collected from the sensors 111, 112 to a digital value by using an Analog to Digital Converter (ADC) equipped therein. Alternatively, each of the voltage sensor 111 and the current sensor 112 may include the ADC therein, and transmit the digital value to the control circuit 130.

The control circuit 130 may be also referred to as 'battery controller' and be implemented in hardware using at least one of application specific integrated circuits (ASICs), digital signal processors (DSPs), digital signal processing devices (DSPDs), programmable logic devices (PLDs), field programmable gate arrays (FPGAs), microprocessors, or electrical units for performing other functions.

The memory 131 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 131 may store data and programs required for the computation operation by the control circuit 130. The memory 131 may store data indicating the results of the computation operation by the control circuit 130. The memory 131 may store data sets and software used to diagnose the degradation state of the battery cell BC. The memory 131 may be integrated in the control circuit 130.

When the relay 20 is turned on during operation of the electrical load 30, 40 and/or the charger 3, the battery 11 is in a charge mode or a discharge mode. When the relay 20 is turned off while the battery 11 is in use in the charge mode or the discharge mode, the battery 11 is changed to a rest mode.

The control circuit 130 may turn on the relay 20 in response to the key-on signal. The control circuit 130 may turn off the relay 20 in response to the key-off signal. The key-on signal is a signal that requests a change from rest to charge or discharge. The key-off signal is a signal that request a change from charge or discharge to rest. Alternatively, instead of the control circuit 130, the system controller 2 may take responsibility for on-off control of the relay 20.

**In** the specification, time-series data of a parameter indicates a time-dependent change history of the parameter. Additionally, a profile (or a curve) indicating a correspondence relationship between two parameters acquired at the same timing for the period of time may be a polynomial equation acquired by mapping time-series data of the two parameters to represent in the form of a 2-dimensional graph, or by applying a predetermined curve fitting logic to a set of two mapped time-series data. Here, the maximum degree of the polynomial equation may be preset.

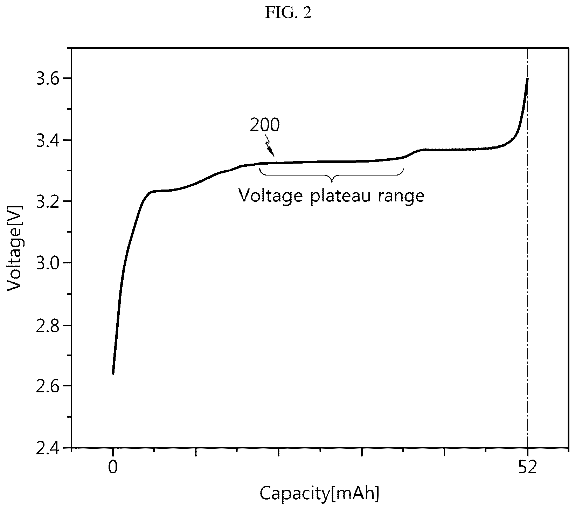

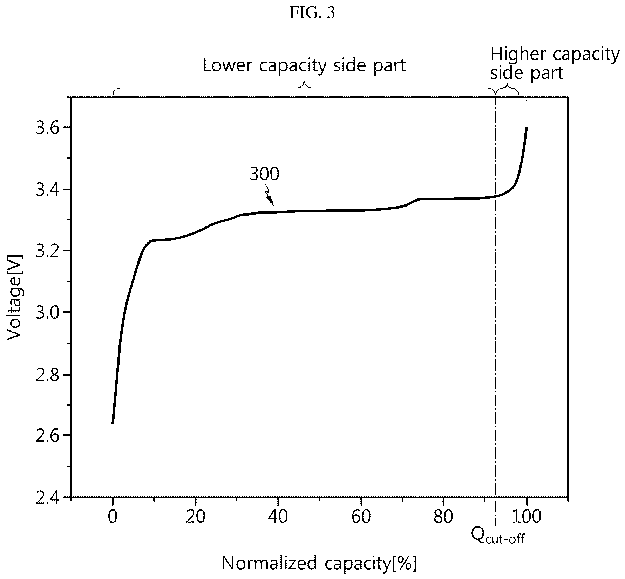

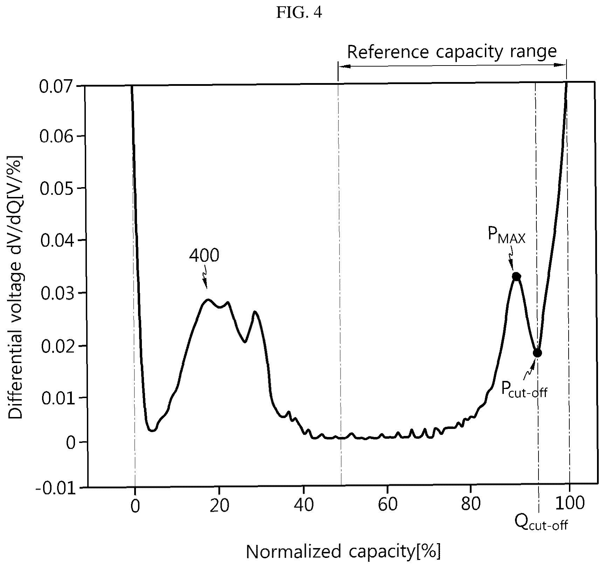

FIG. 2 is a graph showing an example of a Q-V profile of the battery cell, FIG. 3 shows an example of a normalized Q-V profile acquired from the Q-V profile of FIG. 2, and FIG. 4 shows an example of a Q-dV/dQ profile in association with the normalized Q-V profile shown in FIG. 3.

The graph 200 shown in FIG. 2 is a Q-V profile indicating a correspondence relationship between capacity and voltage of the battery cell BC according to capacity-voltage relationship data as described below. In the graph 200, the vertical axis indicates the voltage of the battery cell BC, and the horizontal axis indicates the capacity (unit mAh).

The Q-V profile 200 may be also referred to as a 'capacity-voltage profile', a 'capacity-voltage curve' or a 'full cell profile'. As described above, the battery cell BC has the voltage plateau characteristic, and the Q-V profile 200 shows that voltage is almost uniformly maintained over the capacity range between about 20 mAh and 40 mAh.

Assume that the Q-V profile 200 is acquired through the charge cycle of the battery cell BC. In the charge cycling, constant power or constant current may be used.

**In** the constant power charge cycle, as the voltage of the battery increases, the charge current gradually reduces. Accordingly, not only voltage time-series data indicating time-dependent change history of the voltage of the battery, but also current time-series data indicating time-dependent change history of the current flowing through the battery is essentially required.

In the constant current charge cycle, the charge current having a predetermined current rate is controlled to flow through the battery cell BC. Accordingly, it may be assumed that capacity at a specific time is equal to a value obtained by multiplying the elapsed time from the start time of the constant current charge cycle to the specific time (i.e., a time difference between the start time and the specific time) by the predetermined current rate. Even in the constant current charge cycle, the actual charge current may be temporarily smaller or larger than the intended charge current, so the control circuit 130 may calculate the capacity during charging or discharging in real time by periodically repeatedly accumulating a current measurement value acquired by directly measuring the current flowing in the battery cell BC using the current sensor 112, to generate current time-series data.

The charge cycle may last until the voltage of the battery cell BC changes at least over a predetermined voltage range. The Q-V profile 200 indicates the correspondence relationship between capacity and voltage of the battery cell BC acquired for a period of time until the voltage of the battery cell BC reaches the upper voltage limit of the predetermined voltage range from the lower voltage limit by the constant current charge cycle.

The Q-V profile 200 shown in FIG. 2 shows the voltage of the battery cell BC rises from 2.6V (lower voltage limit) to 3.6V (upper voltage limit) while the capacity of the battery cell BC changes from 0 mAh to 52 mAh. Here, the range between 0 mAh and 52 mAh may be the entire capacity range of the Q-V profile 200, and this corresponds to the predetermined voltage range.

**In** relation, the entire capacity range at least corresponding to the predetermined voltage range may change depending on the degradation state of the battery cell BC. Additionally, even though the degradation state of two different battery cells BC is the same, the capacity range of the two battery cells BC may be different due to the process deviation in the manufacture. To improve the ease and adequacy of data processing required to diagnose the degradation state of the battery cell BC, and ensure the accuracy of the diagnosis result, it is necessary to apply a normalization procedure over the entire capacity range.

The graph 300 shown in FIG. 3 is an example of a normalized Q-V profile acquired by applying the normalization procedure to the Q-V profile 200. In the graph 300, the vertical axis indicates the voltage of the battery cell BC in the same way as FIG. 2, and the horizontal axis indicates normalized capacity (unit %). The normalized capacity may be the term of the equivalent concept to State Of Charge (SOC).

When the voltage and capacity according to the Q-V profile 200 has a mathematical relationship according to the following Equation 1, the voltage and normalized capacity according to the Q-V profile 300 has a mathematical relationship according to the following Equation 2.

<Equation 1>

$$V_B = f_1(Q_B).$$

<Equation 2>

$$V_B = f_2(Q_{B\_normal}) = f_2\left(\frac{Q_B}{Q_{total}} \times 100\right) = f_1\left(\frac{Q_{total} \times Q_{B\_normal}}{100}\right).$$

In Equation 1, $Q_B$ denotes an arbitrary capacity value within the entire capacity range, and $V_B$ denotes a voltage value mapped to $Q_B$ in the Q-V profile 200. In Equation 2, $Q_{B\_normal}$ denotes a normalized capacity value corresponding to $Q_B$, and $Q_{total}$ denotes the size of the entire capacity range (i.e., the upper capacity limit of the entire capacity range). For reference, FIG. 3 shows the result of normalizing each data point of the entire capacity range of FIG. 2 in percentage (a range between 0% and 100%), but this should be understood as an example. For example, instead of the range between 0% and 100%, it may be normalized to a different range between 0 and 1.

The graph 400 shown in FIG. 4 is an example of a Q-dV/dQ profile. The Q-dV/dQ profile 400 may be also referred to as a 'capacity-differential voltage profile' or a 'capacity-differential voltage curve'.

The control circuit 130 differentiates the voltage of the normalized Q-V profile 300 with respect to the normalized capacity to generate the Q-dV/dQ profile 400. Specifically, the control circuit 130 may determine a differential voltage dV/dQ or a ratio of a change dV in the voltage V to a change dQ in the normalized capacity Q[%], and record the Q-dV/dQ profile 400 as relationship data indicating a correspondence relationship between the normalized capacity Q and the differential voltage dV/dQ in the memory.

The control circuit 130 may set a cut-off reference point located in a predetermined reference capacity range from the Q-dV/dQ profile 400. The reference capacity range may partially overlap the capacity range in which the voltage plateau characteristic of the battery cell BC is found.

Specifically, the control circuit 130 may identify a local maximum point $P_{MAX}$ having the maximum differential voltage in the reference capacity range from the Q-dV/dQ profile 400. Subsequently, the control circuit 130 may identify (detect) the cut-off reference point $P_{cut-off}$ located at the higher capacity side than the local maximum point $P_{MAX}$ from the Q-dV/dQ profile 400. The cut-off reference point $P_{cut-off}$ may be a local minimum point having the capacity value $Q_{cut-off}$ in the reference capacity range.

When there are two or more local minimum points in the reference capacity range, the local minimum point having the largest capacity difference from the local maximum point $P_{MAX}$ may be identified as the cut-off reference point $P_{cut-off}$. The cut-off reference point $P_{cut-off}$ may be the last local minimum point in the Q-dV/dQ profile 400 originated from the voltage characteristics of the negative electrode material of the battery cell BC. That is, the higher capacity side than the cut-off reference point $P_{cut-on}$ may be the capacity range in which the voltage characteristics of the positive electrode material of the battery cell BC dominate the voltage characteristics of the negative electrode material. Accordingly, those skilled in the art will easily understand that when only the higher capacity side part of the normalized Q-V profile 300 is analyzed, the positive electrode degradation state of the battery cell BC can be precisely estimated.

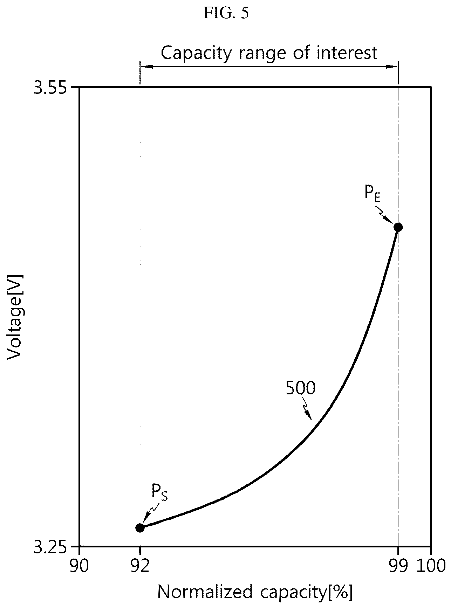

The inventors confirmed, through many experiments, the fact that the voltage characteristics of the negative electrode material are reflected on the higher capacity side part than the cut-off reference point $P_{cut-off}$ to a relatively very small extent compared to the other part of the normalized Q-V profile 300. Accordingly, the inventors recognized that among many different degradation parameters associated with the degradation state of the battery cell BC, a parameter for positive electrode degradation may be accurately diagnosed through analysis of the higher capacity side part of the normalized Q-V profile 300. In the specification, when the normalized Q-V profile 300 is divided into a lower capacity side part and a higher capacity side part on the basis of the cut-off reference point $P_{cut-off}$ as shown in FIG. 3, the higher capacity side part of the normalized Q-V profile 300 may be referred to as a 'Q-V profile of interest' (see 500 in FIG. 5). As shown in FIG. 4, a range between 50% and 99% is set as the reference capacity range.

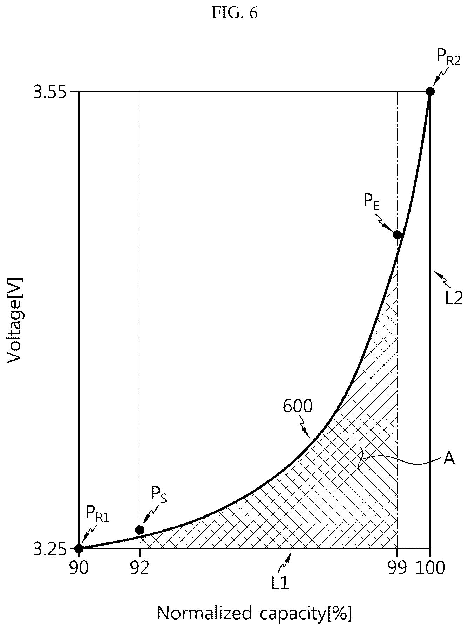

FIG. 5 is a graph showing an example of the Q-V profile of interest extracted from the normalized Q-V profile of FIG. 4, and FIG. 6 shows an example of a corrected Q-V profile of interest acquired from the Q-V profile of interest of FIG. 5.

Referring to FIG. 5, the Q-V profile of interest 500 is an enlarged form of a part of the normalized Q-V profile 300 corresponding to a capacity range of interest (for example, 92% to 99%) using the capacity value (for example, 92%) of the cut-off reference point $P_{cut\text{-}off}$ and the upper capacity limit (for example, 99%) of the reference capacity range as the lower capacity limit and the upper capacity limit, respectively.

In relation, even though the positive electrode degradation state of the battery cell BC is the same, when other degradation factor of the battery cell BC such as the negative electrode degradation state or usable lithium amount is different, the start point, end point and/or shape (for example, curvature) of the Q-V profile of interest 500 extracted from the Q-V profile of interest 500 may change. Accordingly, in the similar way as the normalization procedure applied to the Q-V profile 200, it is necessary to apply the normalization procedure to the Q-V profile of interest 500.

Referring to FIG. 6, it shows the corrected Q-V profile of interest 600 acquired through the normalization procedure (a profile tuning procedure) performed on the Q-V profile of interest 500.

Specifically, the control circuit 130 may generate the corrected Q-V profile of interest 600 by performing at least one of shifting or scaling of the Q-V profile of interest 500 to match the start point $P_S$ and the end point $P_E$ of the Q-V profile of interest 500 to a predetermined first reference point $P_{R1}$ and a predetermined second reference point $P_{R2}$, respectively. The start point $P_S$ of the Q-V profile of interest 500 may be a point having the minimum capacity value of the Q-V profile of interest 500. The end point $P_E$ of the Q-V profile of interest 500 may be a point having the maximum capacity value of the Q-V profile of interest 500.

The capacity value of the first reference point $P_{R1}$ is smaller than the capacity value of the start point $P_S$, and the voltage value of the first reference point $P_{R1}$ is smaller than the voltage value of the start point $P_S$. Additionally, the capacity value of the second reference point $P_{R2}$ is larger than the capacity value of the end point $P_E$, and the voltage value of the second reference point $P_{R2}$ is larger than the voltage value of the end point $P_E$.

The control circuit 130 may perform a first operation of shifting the Q-V profile of interest 500 along at least one of the capacity axis or the voltage axis and a second operation of scaling the Q-V profile of interest 500 along at least one of the capacity axis or the voltage axis to match the start point $P_S$ to the first reference point $P_{R1}$ or the end point $P_E$ to the second reference point $P_{R2}$. The first operation may include at least one of horizontal movement (leftward or rightward movement with respect to the horizontal axis) or vertical movement (upward or downward movement with respect to the vertical axis). The second operation may include at least one of reduction or enlargement on the basis of at least one of the horizontal axis or the vertical axis.

Assume that the 2-dimensional coordinates of the start point $P_S$, the end point $P_E$, the first reference point $P_{R1}$ and the second reference point $P_{R2}$ are $(Q_S, V_S)$, $(Q_E, V_E)$, $(Q_{R1}, V_{R1})$, $(Q_{R2}, V_{R2})$, respectively. In FIG. 6, the 2-dimensional coordinates of the first reference point $P_{R1}$ are (90%, 3.25V), and the 2-dimensional coordinates of the second reference point $P_{R2}$ are (100%, 3.55V). The control circuit 130 may shift the Q-V profile of interest 500 to the lower capacity side by $Q_S - Q_{R1}$ and to the lower voltage side by $V_S - V_{R1}$. Accordingly, because the start point $P_S$ matches the first reference point $P_{R1}$, now it is necessary to match the end point $P_E$ to the second reference point $P_{R2}$. Accordingly, the control circuit 130 may scale the Q-V profile of interest 500 at a ratio of $(Q_{R2} - Q_{R1})/(Q_E - Q_S)$ along the capacity axis and at a ratio of $(V_{R2} - V_{R1})/(V_E - V_S)$ along the capacity axis. Accordingly, the operation of generating the corrected Q-V profile of interest 600 from the Q-V profile of interest 500 is completed. As a result, the two points $P_S$, $P_E$ in the Q-V profile of interest 600 may deviate from the corrected Q-V profile of interest 600 as shown in FIG. 6.

The control circuit 130 may determine a profile feature parameter based on the corrected Q-V profile of interest 600. The control circuit 130 may determine the area of a region of interest A defined by the corrected Q-V profile of interest 600, the first reference point $P_{R1}$ and the second reference point $P_{R2}$ as the profile feature parameter. That is, the region of interest A may be a closed region surrounded by the corrected Q-V profile of interest 600, a first reference line and a second reference line. The first reference line may be a horizontal line (parallel to the capacity axis) passing through the first reference point $P_{R1}$. The second reference line may be a vertical line (parallel to the voltage axis) passing through the second reference point $P_{R2}$.

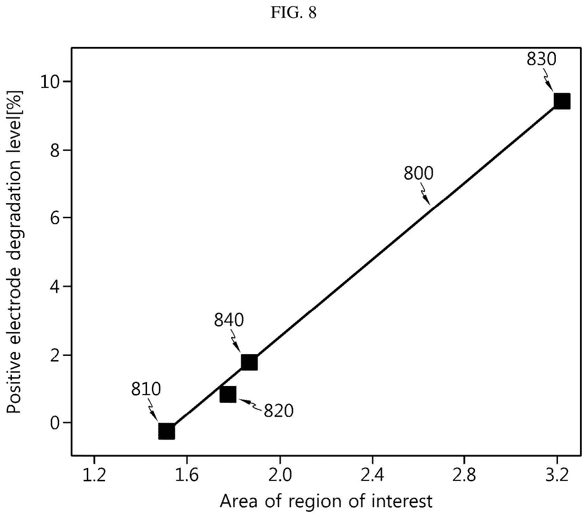

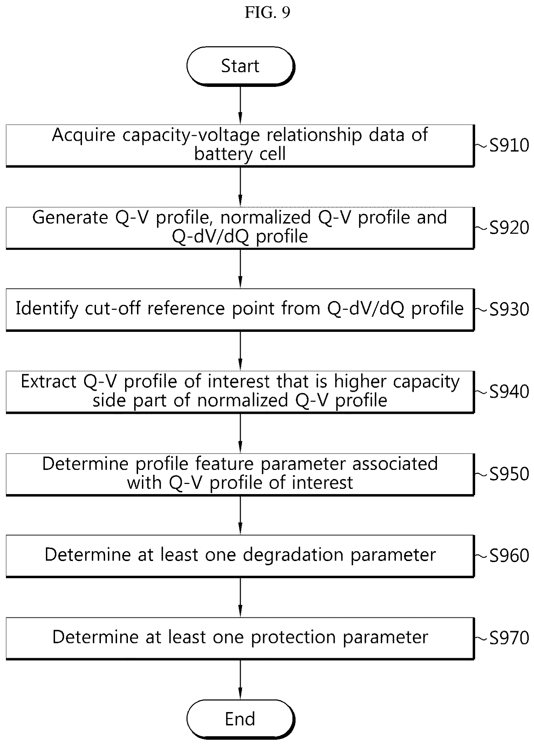

The control circuit 130 may determine a first degradation parameter associated with the degradation state of the battery cell BC by inputting the area of the region of interest A determined as the profile feature parameter to a linear regression model as an input variable. The first degradation parameter may indicate a capacity reduction ratio by positive electrode degradation of the battery cell. The capacity reduction ratio caused by positive electrode degradation may be referred to as a 'positive electrode degradation level' or a 'positive electrode degradation derived capacity reduction ratio'. Hereinafter, the linear regression model will be described in more detail with reference to FIGs. 8 and 9.

The inventors created relationship data that may be used to generate the linear regression model by a process of forcedly degrading a plurality of battery cells BC prepared for an experiment to different positive electrode degradation levels, a process of calculating the area of a region of interest for each of the forcedly degraded battery cells BC, a process of dissembling each of the forcedly degraded battery cells BC to fabricate a positive electrode half cell and a process of measuring and recording the usable capacity of each positive electrode half cell in that order.

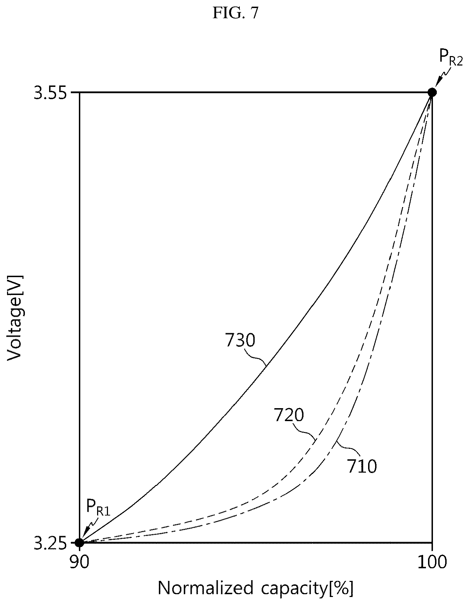

FIG. 7 is a diagram referenced in exemplarily describing a relationship between different positive electrode degradation levels and the corrected Q-V profiles of interest, and FIG. 8 is a diagram referenced in exemplarily describing a relationship between different positive electrode degradation levels and the area of the region of interest.

FIG. 7 shows a pattern in which the corrected Q-V profile of interest changes with the increasing positive electrode degradation level. The positive electrode degradation level may refer to a positive electrode degradation derived capacity reduction ratio.

Referring to FIG. 7, a curve 710 indicates the corrected Q-V profile of interest acquired at the positive electrode degradation level of 0%, i.e., when the positive electrode is fresh, a curve 720 indicates the corrected Q-V profile of interest acquired at the positive electrode degradation level of 1.75%, and a curve 730 indicates the corrected Q-V profile of interest acquired at the positive electrode degradation level of 9.40%.

That is, as the positive electrode degradation level is higher, the corrected Q-V profile of interest gradually changes close to a shape of a straight line connecting the first reference point $P_{R1}$ to the second reference point $P_{R2}$, and accordingly the area of the region of interest increases, as can be seen from FIG. 7.

Referring to FIG. 8, the linear regression model 800 may be prepared beforehand as a relationship function between the profile feature parameter (the area of the region of interest) and the positive electrode degradation state. The point 810 is associated with the curve 710 of FIG. 7, the point 820 is associated with the curve 720 of FIG. 7, and the point 830 is associated with the curve 730 of FIG. 7. Although not fully shown, in addition to the points 810, 820, 830, additional points were acquired from the above-described experiment and then used to acquire the linear regression model 800 through linear regression analysis. The linear regression model 800 may be pre-stored in the memory 131. The following Equation 3 is an example of the linear regression model 800.

<Equation 3>

$$y = Ax + B.$$

In Equation 3, the A and B are two coefficients indicating the slope of the straight line and the y axis intercept according to the linear regression model 800, respectively. x denotes the area of the region of interest as the input variable, and y denotes the positive electrode degradation level as the output variable. The A and B may change depending on the type and composition ratio of each of the positive electrode material and the negative electrode material. Accordingly, the A and B may be properly tuned according to the type and manufacturing information (for example, the type and composition ratio of each of the positive electrode material and the negative electrode material) of the battery cell BC provided for diagnosis. For example, the A and B of the linear regression model 800 shown in FIG. 8 are 5.63 and -8.76, respectively.

The control circuit 130 may input the area of the region of interest (A in FIG. 6) acquired from the battery cell BC having an unknown positive electrode degradation state to the linear regression model 800 as the input variable x, and acquire the positive electrode degradation level as the output variable y. The point 840 is a point on the linear regression model 800 corresponding to the area of the region of interest (A in FIG. 6).

The following TABLE 1 summarizes a relationship between the number of the above-described constant power charge cycles (cycle number), the total capacity reduction ratio, the area of the region of interest, the first degradation parameter (positive electrode degradation derived capacity reduction ratio) and the second degradation parameter (loss of available lithium derived capacity reduction ratio). Here, the available lithium may refer to an amount of lithium ions that may participate in the charge/discharge reaction of the battery cell BC.

[TABLE 1]

| Classification | Total capacity reduction ratio (%) | Area of region of interest | Positive electrode degradation derived capacity reduction ratio (%) | loss of available lithium derived capacity reduction ratio (%) |
|---|---|---|---|---|
| Cycle number=0 | 0 | 1.51 | 0 | 0 |
| Cycle number=100 | 3.40 | 1.63 | 0.87 | 2.53 |
| Cycle umber=200 | 6.70 | 1.75 | 1.75 | 4.95 |
| Cycle number=600 | 16.50 | 3.22 | 9.40 | 7.10 |

According to TABLE 1, it can be seen that as the cycle number increases, each of the total capacity reduction ratio, the area of the region of interest, the positive electrode degradation derived capacity reduction ratio and the loss of available lithium derived capacity reduction ratio increases together. For reference, the cycle number may be counted by one each time a cycle of charge (or discharge) with the constant power (or constant current) is completed.

The total capacity reduction ratio may be a ratio of a reduction of full charge capacity by degradation to the full charge capacity when the battery cell BC is fresh. When it is assumed that the full charge capacity in the fresh battery = P, the full charge capacity in the degraded battery = U, the reduction of full charge capacity = W, W = P-U, the total capacity reduction ratio = (W/P) X 100%.

The inventors recognized the fact that the sum of the positive electrode degradation derived capacity reduction ratio and the loss of available lithium derived capacity reduction ratio substantially equals the total capacity reduction ratio. Accordingly, the control circuit 130 may determine the loss of available lithium derived capacity reduction ratio as the second degradation parameter by subtracting the positive electrode degradation level determined through the above-described Equation 3 from the total capacity reduction ratio.

FIG. 9 is a flowchart schematically showing a battery diagnosis method according to an embodiment of the present disclosure. The method according to FIG. 9 includes the steps S910 to S960. The method according to FIG. 9 may further include the step S970.

Referring to FIGs. 1 to 9, in step S910, the control circuit 130 acquires capacity-voltage relationship data of the battery cell BC by using the data acquisition unit. In the specification, acquisition of data or information may refer to generation through software processing, input through a user or an input device and/or reception through a communication channel.

For example, when the data acquisition unit includes the sensing unit 110, the control circuit 130 may generate voltage time series and capacity time series based on the detection signal generated by the sensing unit 110. The capacity-voltage relationship data may include the voltage time series and the capacity time series. Data points of the voltage time series and data points of current time series may be mapped in a one-to-one relationship.

The voltage time series may indicate time-dependent change history of voltage of the battery cell BC while the battery cell BC is charged (or discharged) with the constant power (or constant current) over the predetermined voltage range. The current time series may indicate time-dependent change history of the current flowing through the battery cell BC for the same period of time as the period of time during which the voltage time series is acquired.

As another example, when the data acquisition unit includes the communication circuit 150, the control circuit 130 may receive the capacity-voltage relationship data from an external device by using the communication circuit 150.

In step S920, the control circuit 130 generates the Q-V profile 200, the normalized Q-V profile 300 and the Q-dV/dQ profile 400 of the battery cell BC based on the capacity-voltage relationship data.

In step S930, the control circuit 130 identifies the cut-off reference point $P_{cut-off}$ from the Q-dV/dQ profile 400.

In step S940, the control circuit 130 extracts the Q-V profile of interest 500 that is the higher capacity side part of the normalized Q-V profile 300 on the basis of the capacity value $Q_{cut-off}$ of the cut-off reference point $P_{cut-off}$.

In step S950, the control circuit 130 determines the profile feature parameter associated with the Q-V profile of interest 500.

In step S960, the control circuit 130 determines at least one degradation parameter associated with the degradation state of the battery cell BC based on the profile feature parameter. Accordingly, at least one of the first degradation parameter or the second degradation parameter may be determined.

In step S970, the control circuit 130 may determine at least one protection parameter for the battery cell BC based on the at least one degradation parameter determined in the step S960. For example, at least one of maximum charge voltage, minimum discharge voltage, maximum allowable current or maximum allowable power may be determined as the protection parameter.

When (i) the voltage of the battery cell BC is equal to or more than the maximum charge voltage or is equal to or less than the minimum discharge voltage, (ii) the current flowing through the battery cell BC is equal to or more than the maximum allowable current, and/or (iii) the charge or discharge power of the battery cell BC is equal to or more than the maximum allowable power, the control circuit 130 may change the relay 20 to an OFF state, or transmit an operation stop request to the inverter 30 and/or the charger 3.

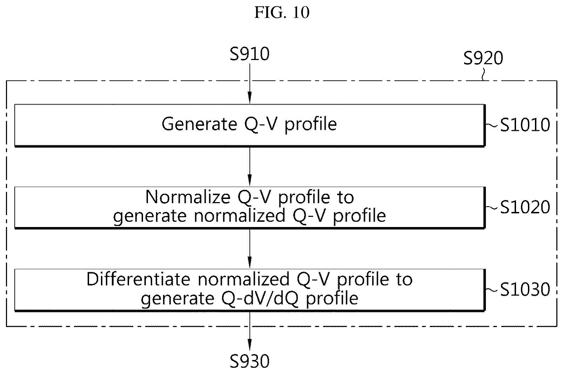

FIG. 10 is a flowchart exemplarily showing the sub-routines that may be included in the step S920 in FIG. 9.

In step S1010, the control circuit 130 generates the Q-V profile 200 from the voltage time-series data generated in the step S910.

In step S1020, the control circuit 130 normalizes the Q-V profile 200 based on the entire capacity range of the Q-V profile 200 to generate the normalized Q-V profile 300.

In step S1030, the control circuit 130 may differentiate the normalized Q-V profile 300 to generate the Q-dV/dQ profile 400 indicating the correspondence relationship between the normalized capacity and the differential voltage of the battery cell BC.

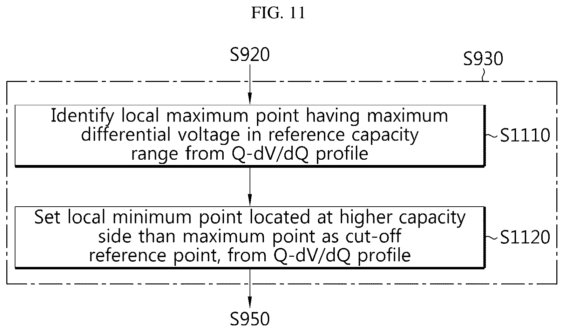

FIG. 11 is a flowchart exemplarily showing the sub-routines that may be included in the step S930 in FIG. 9.

Referring to FIG. 11, in step S1110, the control circuit 130 identifies the local maximum point $P_{MAX}$ having the maximum differential voltage in the reference capacity range from the Q-dV/dQ profile 400.

In step S1120, the control circuit 130 sets the local minimum point located at the higher capacity side than the local maximum point $P_{MAX}$ as the cut-off reference point $P_{cut-off}$, from the Q-dV/dQ profile 400.

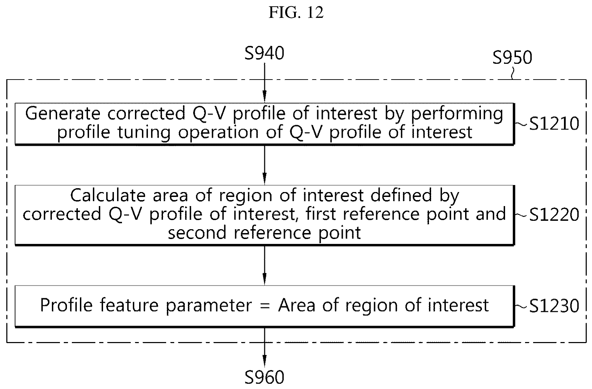

FIG. 12 is a flowchart exemplarily showing the sub-routines that may be included in the step S950 in FIG. 9.

Referring to FIG. 12, in step S1210, the control circuit 130 generates the corrected Q-V profile of interest 600 by performing the shifting operation and the scaling operation of the Q-V profile of interest 500 to match the start point $P_S$ and the end point $P_E$ of the Q-V profile of interest 500 to the predetermined first reference point $P_{R1}$ and the predetermined second reference point $P_{R2}$, respectively.

In step S1220, the control circuit 130 calculates the area of the region of interest A defined by the corrected Q-V profile of interest 600, the first reference point $P_{R1}$ and the second reference point $P_{R2}$. The region of interest A may be a region surrounded by the corrected Q-V profile of interest 600, the first reference line L1 and the second reference line L2. The first reference line L1 may be a horizontal line passing through the first reference point $P_{R1}$. The second reference line L2 may be a vertical line passing through the second reference point $P_{R2}$.

In step S1230, the control circuit 130 determines the profile feature parameter to be equal to the area of the region of interest A. In step S970, the control circuit 130 may determine the first degradation parameter y associated with the degradation state of the battery cell BC by using the profile feature parameter determined in the step S1130 as the input variable x of the linear regression model 800 (see Equation 3). The linear regression model 800 may be prepared beforehand as a relationship function indicating the correspondence relationship between the profile feature parameter and the positive electrode degradation state.

The embodiments of the present disclosure as described above are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to a limited number of embodiments and drawings, the present disclosure is not limited thereto and it is obvious to those skilled in the art that various modifications and changes may be made thereto within the technical aspect of the present disclosure and the scope of the appended claims and their equivalents.

Additionally, as many substitutions, modifications and changes may be made to the present disclosure as described above by those skilled in the art without departing from the technical aspect of the present disclosure, the present disclosure is not limited by the above-described embodiments and the accompanying drawings, and some or all of the embodiments may be selectively combined to allow various modifications.

**Claims**

1. A battery diagnosis apparatus comprising:

    a data acquisition unit configured to acquire capacity-voltage relationship data of a battery cell; and
    a control circuit configured to generate a Q-V profile indicating a correspondence relationship between a capacity and a voltage of the battery cell, a normalized Q-V profile indicating a correspondence relationship between a normalized capacity and the voltage of the battery cell and a Q-dV/dQ profile indicating a correspondence relationship between the normalized capacity and a differential voltage of the battery cell based on the capacity-voltage relationship data,
    wherein the control circuit is configured to:

        identify a cut-off reference point located in a reference capacity range from the Q-dV/dQ profile,
        determine a profile feature parameter associated with a Q-V profile of interest, wherein the Q-V profile of interest is a higher capacity side part of the normalized Q-V profile on the basis of a capacity value of the cut-off reference point, and
        determine at least one degradation parameter of the battery cell based on the profile feature parameter.

2. The battery diagnosis apparatus according to claim 1, wherein the control circuit is configured to:

    generate the normalized Q-V profile by normalizing the Q-V profile based on an entire capacity range of the Q-V profile, and
    generate the Q-dV/dQ profile by differentiating the normalized Q-V profile.

3. The battery diagnosis apparatus according to claim 1, wherein the control circuit is configured to set a local minimum point in the reference capacity range as the cut-off reference point from the Q-dV/dQ profile.

4.  The battery diagnosis apparatus according to claim 1, wherein the control circuit is configured to:

    generate a corrected Q-V profile of interest by performing a profile tuning procedure for matching a start point and an end point of the Q-V profile of interest to a first reference point and a second reference point, respectively, and determine an area of a region of interest defined by the corrected Q-V profile of interest, the first reference point and the second reference point as the profile feature parameter.

5.  The battery diagnosis apparatus according to claim 4, wherein the control circuit is configured to determine a first degradation parameter by using the determined area as an input variable of a linear regression model, and wherein the linear regression model is prepared beforehand as a relationship function between the profile feature parameter and a positive electrode degradation state.

6.  The battery diagnosis apparatus according to claim 5, wherein the first degradation parameter indicates a capacity reduction ratio by positive electrode degradation of the battery cell.

7.  The battery diagnosis apparatus according to claim 5, wherein the control circuit is configured to determine a second degradation parameter based on a total capacity reduction ratio of the battery cell and the first degradation parameter, and
    wherein the second degradation parameter indicates a capacity reduction ratio by loss of available lithium of the battery cell.

8.  The battery diagnosis apparatus according to claim 1, wherein the capacity-voltage relationship data indicates a capacity change history and a voltage change history of the battery while the battery cell is charged or discharged.

9.  A battery pack comprising the battery diagnosis apparatus according to any one of claims 1 to 8.

10. An electric vehicle comprising the battery pack according to claim 9.

11. A battery diagnosis method comprising:

    acquiring capacity-voltage relationship data of a battery cell;
    generating a Q-V profile indicating a correspondence relationship between a capacity and a voltage of the battery cell, a normalized Q-V profile indicating a correspondence relationship between a normalized capacity and the voltage of the battery cell and a Q-dV/dQ profile indicating a correspondence relationship between the normalized capacity and a differential voltage of the battery cell based on the capacity-voltage relationship data;
    identifying a cut-off reference point located in a reference capacity range from the Q-dV/dQ profile;
    determining a profile feature parameter associated with a Q-V profile of interest, wherein the Q-V profile of interest is a higher capacity side part of the normalized Q-V profile on the basis of a capacity value of the cut-off reference point; and
    determining at least one degradation parameter of the battery cell based on the profile feature parameter.

12. The battery diagnosis method according to claim 11, wherein the generating of the Q-dV/dQ profile comprises:

    generating the normalized Q-V profile by normalizing the Q-V profile based on an entire capacity range of the Q-V profile; and
    generating the Q-dV/dQ profile by differentiating the normalized Q-V profile.

13. The battery diagnosis method according to claim 11, wherein the determining of the profile feature parameter of the battery cell comprises:

    generating a corrected Q-V profile of interest by performing a profile tuning procedure for matching a start point and an end point of the Q-V profile of interest to a first reference point and a second reference point, respectively; and
    determining an area of a region of interest defined by the corrected Q-V profile of interest, the first reference point and the second reference point as the profile feature parameter.

14. The battery diagnosis method according to claim 13, wherein the determining of the at least one degradation parameter of the battery cell comprises determining a first degradation parameter by inputting the determined area to a linear regression model as an input variable, and
wherein the linear regression model is prepared beforehand as a relationship function between the profile feature parameter and a positive electrode degradation state.

15. The battery diagnosis method according to claim 14, wherein the determining of the at least one degradation parameter of the battery cell further comprises:

determining a second degradation parameter based on a total capacity reduction ratio of the battery cell and the first degradation parameter, and
wherein the second degradation parameter indicates a capacity reduction ratio by loss of available lithium of the battery cell.

FIG. 1

FIG. 2

FIG. 3

FIG. 4

FIG. 5

FIG. 6

FIG. 7

FIG. 8

FIG. 9

Start

Acquire capacity-voltage relationship data of battery cell ~S910

Generate Q-V profile, normalized Q-V profile and Q-dV/dQ profile ~S920

Identify cut-off reference point from Q-dV/dQ profile ~S930

Extract Q-V profile of interest that is higher capacity side part of normalized Q-V profile ~S940

Determine profile feature parameter associated with Q-V profile of interest ~S950

Determine at least one degradation parameter ~S960

Determine at least one protection parameter ~S970

End

FIG. 10

S910                                    S920

Generate Q-V profile                          ~S1010

Normalize Q-V profile to
generate normalized Q-V profile               ~S1020

Differentiate normalized Q-V profile to
generate Q-dV/dQ profile                      ~S1030

S930

FIG. 11

S920    S930

Identify local maximum point having maximum
differential voltage in reference capacity
range from Q-dV/dQ profile    ~S1110

Set local minimum point located at higher capacity
side than maximum point as cut-off
reference point, from Q-dV/dQ profile    ~S1120

S950

FIG. 12

S940

S950

Generate corrected Q-V profile of interest by performing
profile tuning operation of Q-V profile of interest ~S1210

Calculate area of region of interest defined by
corrected Q-V profile of interest, first reference point and ~S1220
second reference point

Profile feature parameter = Area of region of interest ~S1230

S960

**EP 4 653 896 A1**

## INTERNATIONAL SEARCH REPORT

| International application No. |
|---|
| **PCT/KR2024/010819** |

| A. | CLASSIFICATION OF SUBJECT MATTER |
|---|---|

**G01R 31/392**(2019.01)i; **G01R 31/396**(2019.01)i; **G01R 31/385**(2019.01)i; **G01R 31/367**(2019.01)i; **G01R 31/36**(2006.01)i; **G01R 31/382**(2019.01)i; **G01R 19/165**(2006.01)i; **H01M 10/052**(2010.01)i; **H01M 10/48**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); G01R 31/36(2006.01); G01R 31/367(2019.01); G01R 31/382(2019.01); G01R 31/3842(2019.01); G01R 31/388(2019.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 정규화(generalization), 진단(diagnosis), 용량 변화(capacity change), 미분(differentiation)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2022-0009918 A (LG ENERGY SOLUTION, LTD.) 25 January 2022 (2022-01-25)<br>See paragraphs [0040]-[0050] and [0173]-[0184], claims 1 and 15 and figures 1 and 10. | 1-15 |
| A | KR 10-2022-0021730 A (LG ENERGY SOLUTION, LTD.) 22 February 2022 (2022-02-22)<br>See paragraphs [0034]-[0131], claims 1-8 and figures 1-7. | 1-15 |
| A | JP 2022-144006 A (HONDA MOTOR CO., LTD.) 03 October 2022 (2022-10-03)<br>See paragraphs [0030]-[0044], claim 1 and figures 4-6. | 1-15 |
| A | JP 2009-080093 A (HITACHI VEHICLE ENERGY LTD.) 16 April 2009 (2009-04-16)<br>See paragraphs [0014]-[0024] and figure 2. | 1-15 |
| A | KR 10-2022-0015998 A (LG ENERGY SOLUTION, LTD.) 08 February 2022 (2022-02-08)<br>See paragraphs [0071]-[0077] and figures 3-4. | 1-15 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 November 2024** | **13 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/010819**

| Patent document cited in search report | | | Publication date (day/month/year) | Patent family member(s) | | | Publication date (day/month/year) |
|---|---|---|---|---|---|---|---|
| KR | 10-2022-0009918 | A | 25 January 2022 | CN | 114846673 | A | 02 August 2022 |
| | | | | EP | 4064412 | A1 | 28 September 2022 |
| | | | | JP | 2023-503971 | A | 01 February 2023 |
| | | | | JP | 7293569 | B2 | 20 June 2023 |
| | | | | US | 2023-0039356 | A1 | 09 February 2023 |
| | | | | WO | 2022-015116 | A1 | 20 January 2022 |
| KR | 10-2022-0021730 | A | 22 February 2022 | CN | 115413382 | A | 29 November 2022 |
| | | | | EP | 4131571 | A1 | 08 February 2023 |
| | | | | JP | 2023-517738 | A | 26 April 2023 |
| | | | | JP | 7372007 | B2 | 31 October 2023 |
| | | | | KR | 10-2596153 | B1 | 30 October 2023 |
| | | | | US | 11990590 | B2 | 21 May 2024 |
| | | | | US | 2023-0207910 | A1 | 29 June 2023 |
| | | | | US | 2024-0274902 | A1 | 15 August 2024 |
| | | | | WO | 2022-035032 | A1 | 17 February 2022 |
| JP | 2022-144006 | A | 03 October 2022 | CN | 115113079 | A | 27 September 2022 |
| | | | | JP | 7235790 | B2 | 08 March 2023 |
| | | | | US | 2022-0299577 | A1 | 22 September 2022 |
| JP | 2009-080093 | A | 16 April 2009 | CN | 101383438 | A | 11 March 2009 |
| | | | | CN | 101383438 | B | 27 October 2010 |
| | | | | EP | 2053414 | A2 | 29 April 2009 |
| | | | | EP | 2053414 | A3 | 06 May 2009 |
| | | | | EP | 2053414 | B1 | 03 July 2013 |
| | | | | JP | 4884404 | B2 | 29 February 2012 |
| KR | 10-2022-0015998 | A | 08 February 2022 | CN | 115362381 | A | 18 November 2022 |
| | | | | EP | 4155745 | A1 | 29 March 2023 |
| | | | | EP | 4155745 | B1 | 30 October 2024 |
| | | | | JP | 2023-516720 | A | 20 April 2023 |
| | | | | JP | 7380974 | B2 | 15 November 2023 |
| | | | | US | 12025671 | B2 | 02 July 2024 |
| | | | | US | 2023-0119100 | A1 | 20 April 2023 |
| | | | | WO | 2022-025726d | A1 | 03 February 2022 |

REFERENCES CITED IN THE DESCRIPTION

**Patent documents cited in the description**

- KR 1020230117255